(19) Europäisches Patentamt

European Patent Office

Office européen des brevets

(11) **EP 1 164 382 B1**

(12) **EUROPÄISCHE PATENTSCHRIFT**

(45) Veröffentlichungstag und Bekanntmachung des Hinweises auf die Patenterteilung:
**18.01.2006 Patentblatt 2006/03**

(51) Int Cl.:
***G01R 33/567*** *(2006.01)*

(21) Anmeldenummer: **01000204.6**

(22) Anmeldetag: **12.06.2001**

(54) **MR-Bildgebungsverfahren mit Bewegungskompensation**

MRI method with motion compensation

Procédé d'IRM avec compensation de mouvement

(84) Benannte Vertragsstaaten:
**DE FR GB NL**

(30) Priorität: **15.06.2000 DE 10029592**

(43) Veröffentlichungstag der Anmeldung:
**19.12.2001 Patentblatt 2001/51**

(73) Patentinhaber:
- **Philips Intellectual Property & Standards GmbH
  20099 Hamburg (DE)**
  Benannte Vertragsstaaten:
  **DE**
- **Koninklijke Philips Electronics N.V.
  5621 BA Eindhoven (NL)**
  Benannte Vertragsstaaten:
  **FR GB NL**

(72) Erfinder:
- **Nehrke, Kay, Dr.,
  c/o Philips Corp.Int.Prop.GmbH
  52064 Aachen (DE)**
- **Börnert, Peter, Dr.,
  c/o Philips Corp.Int.Prop.GmbH
  52064 Aachen (DE)**
- **Aldefeld, Bernd, Dr.,
  c/o Philips Corp.Int.Prop.GmbH
  52064 Aachen (DE)**
- **Kuhn, Michael, Dr.,
  c/o Philips Corp.Int.Prop.GmbH
  52064 Aachen (DE)**
- **Manke, Dirk,
  c/o Philips Corp.Int.Prop.GmbH
  52064 Aachen (DE)**

(74) Vertreter: **Volmer, Georg
Philips Intellectual Property & Standards GmbH,
Postfach 50 04 42
52088 Aachen (DE)**

(56) Entgegenhaltungen:
**US-A- 5 800 354**

- **YI WANG ET AL: "Respiratory motion of the heart: kinematics and the implications for the spatial resolution in coronary imaging" MAGNETIC RESONANCE IN MEDICINE, MAY 1995, USA, Bd. 33, Nr. 5, Seiten 713-719, XP002260907 ISSN: 0740-3194**
- **STUBER M ET AL: "BREATHHOLD THREE-DIMENSIONAL CORONARY MAGNETIC RESONANCE ANGIOGRAPHY USING REAL-TIME NAVIGATOR TECHNOLOGY" JOURNAL OF CARDIOVASCULAR MAGNETIC RESONANCE, DEKKER, NEW YORK, NY, US, Bd. 1, Nr. 3, November 1999 (1999-11), Seiten 233-238, XP009011791 ISSN: 1097-6647**

EP 1 164 382 B1

**Beschreibung**

Die Erfindung betrifft ein MR-Verfahren zur Darstellung eines zumindest teilweise bewegten Objektes in einem Untersuchungbereich, wobei während einer MR-Untersuchung in Anwesenheit eines stationären Magnetfeldes die Kernmagnetisierung durch Sequenzen mit mindestens je einem Hochfrequenzimpuls mit definierter Frequenz angeregt und eine Anzahl von unter dem Einfluß von zusätzlichen magnetischen Gradientenfeldem entstandenen, mit definierter Phasenlage empfangenen MR-Signalen ausgewertet wird und wobei zur Bewegungskompensation ein Bewegungsparameter des Objekts fortlaufend gemessen und die Parameter der Sequenz in Abhängigkeit von der Messung variiert werden. Außerdem betrifft die Erfindung ein MR-Gerät zur Durchführung des Verfahrens sowie ein Computerprogramm mit dessen Hilfe die Steuereinheit eines MR Gerätes so gesteuert wird; dass das Verfahren ablaufen kann.

Bewegte Objekte müssen insbesondere in der medizinischen Bildgebung dargestellt werden, beispielsweise das Herz oder die Herzkranzgefäße. In diesem Zusammenhang ist es aus einer Studie von Wang et al (MRM 33:713-719 (1995)) bekannt, dass sich das menschliche Herz proportional zu der durch die Atmung verursachten Zwerchfellbewegung verschiebt. Überwacht man daher die Zwerchfellbewegung, beispielsweise mittels sogenannter Navigatorimpulse und variiert davon abhängig die Frequenz bzw. die Phase des Hochfrequenzimpulses bzw. der Phasenlage der MR-Signale ("Slice tracking"), dann läßt sich die Herzbewegung zumindest teilweise kompemsieren, und die Bewegungsartefakte im MR-Bild werden reduziect.

Der Vorteil dieses Verfahrens gegenüber einem Verfahren, bei dem nur in einer bestimmten Phase der Atembewegung MR-Signale akquiriert werden, besteht in einer Verringerung der für die Akquisition sämtlicher MR-Signale erforderlichen Meßzeit. Ein Nachteil besteht darin, dass die Bewegungskompensation relativ ungenau ist, weil die Bewegung des Herzens als Funktion der Zwerchfellbewegung bei unterschiedlichen Patienten unterschiedlich verläuft. Um diesen Nachteil auszugleichen, ist es aus einer Veröffentlichung von Taylor et al in ISMRM, 322 (1998) bekannt, individuelle Korrekturfaktoren aus vor der eigentlichen MR-Untersuchung aufgenommenen MR-Bildern abzuleiten, die das Herz in unterschiedlichen Atemphasen darstellen. Hiermit ist zwar eine genauere Kompensation möglich, doch erfordert die Ermittlung der individuellen Korrekturfaktoren eine sorgfältige Auswertung der zuvor angefertigten MR-Bilder durch den Untersucher.

Aufgabe der vorliegenden Erfindung ist es, ein Verfahren der eingangs genannten Art so auszugestalten, dass sich auf einfache Weise eine relativ genaue Bewegungskompensation ergibt. Diese Aufgabe wird erfindungsgemäß durch das Verfahren nach Anspruch 1 gelöst.

Nach der Erfindung erfolgt die individuelle Anpassung in einer der eigentlichen MR-Untersuchung vorangehenden Präparationsphase. Dabei werden n miteinander korrelierte Bewegungsparameter quasi gleichzeitig gemessen. Aus dieser Messung läßt sich die Korrelation zwischen den einzelnen Bewegungsparameter ermitteln. Bei der nachfolgenden MR-Untersuchung müssen dann nur noch m Bewegungsparameter gemessen werden (z.B. die Zwerchfellbewegung, m = 1), woraus sich aufgrund der vorher ermittelten Korrelation die übrigen Bewegungsparameter ableiten lassen. Davon abhängig können die Parameter der Sequenz (z.B. Frequenz bzw. Phasenlage des Hochfrequenzimpulses bzw. des MR-Signals) so variiert werden, dass sich eine Bewegungskompensation ergibt.

Das erfindungsgemäße Verfahren läuft automatish ab und erfordert keine Auswertung von vorher angefertigten MR-Bildem durch einen Untersucher. Obwohl für die genaue Bewegungskompensation die Messung einer größeren Anzahl (n) von Bewegungsparametern erforderlich ist, wird die eigentliche MR-Untersuchung dadurch nicht beeinträchtigt, weil die Erfassung dieser Bewegungsparameter in der vorangehenden Präparationsphase erfolgt.

Die in Anspruch 2 beschriebene Ausgestaltung des Verfahrens erlaubt eine noch genauere Bewegungskompensation. Werden nämlich mindestens zwei Bewegungsparameter erfaßt, dann kann man kompliziertere Bewegungen kompensieren als eine einfache Translation. Beispielsweise kann man berücksichtigen, dass das Herz durch die Zwerchfellbewegung komprimiert bzw. expandiert wird. Die Kompression oder Expansion, aber auch eine Rotation kann aber nur dadurch kompensiert werden, dass außer Frequenz und Phasenlage des Hochfrequenzimpulses bzw. des MR-Signals auch die während einer Sequenz wirksamen magnetischen Gradientenfelder variiert werden.

Anspruch 3 beschreibt eine bevorzugte Möglichkeit zur Messung der Bewegungsparameter. Navigatorimpulse ermöglichen die Anregung eines in zwei Dimensionen beschränkten Bereiches zB. eines zylinderförmigen Stabes (pencil beam). Trifft ein solcher Navigatorimpuls beispielsweise auf das Zwerchfell eines Patienten, dann läßt sich dessen Bewegungszustand bzw. die Atmung des Patienten durch Auswertung der nach dem Navigatorimpuls empfangenen MR-Signale bestimmen. Es kann damit die Belegung eines räumlich beschränkten Bereichs genau gemessen werden.

Anspruch 4 beschreibt eine für die Darstellung des Herzens (oder der Herzkramgefäße) geeignete Ausgestaltung des Verfahrens. Das Herz bewegt sich ja nicht nur infolge der Atembewegung sondern auch aufgrund der Herzaktion, wobei ein Herzzyklus wesentlich kürzer ist als ein Atemzyklus. In der späten Diastole der Herzaktion (kurz vor der R-Zacke im EKG) gibt es aber eine bewegungsarme Phase von ca 100 ms. Wenn man die Sequenzen nur in dieser bewegungsarmen Phase erzeugt, verursacht der Herzzyklus keine zusätzlichen Bewegungsartefakte.

Gemäß Anspruch 5 kann die Zeit für die Akquisition aller erforderlichen MR-Signale verkürzt werden. Dazu ist es erforderlich Sequenzen zu verwenden deren Dauer kürzer ist als die bewegungsarme Phase des Herzens. Da diese Phase aber kurz ist im Vergleich zu einem Atemzyklus, genügt es, wenn die Bewegungsparameter in dem betreffenden Herzzyklus nur einmal erfaßt werden.

Anspruch 6 beschreibt ein MR-Gerät zur Durchführung des Verfahrens und Anspruch 7 ein Computerprogramm für eine die Verfahrensabläufe steuernden Steuereinheit eines solchen MR-Gerätes.

Die Erfindung wird nachstehend anhand der Zeichnungen näher erläutert. Es zeigen:

Fig 1     Ein MR-Gerät mit dem die Erfindung ausführbar ist,
Fig 2     die Lage der Meßpunkte bei der Erfassung der Bewegungsparameter,
Fig. 3    den zeitlichen Verlauf der Bewegung an den verschieden Meßpunkten,
Fig 4     die Korrelation zwischen diesen Bewegungen,
Fig 5     einen Herzzyklus und die Lage der verschieden Akquisitionsschritte während des Herzzyklus, und
          den zeitlichen Verlauf einer Sequenz bei der MR-Bildgebung

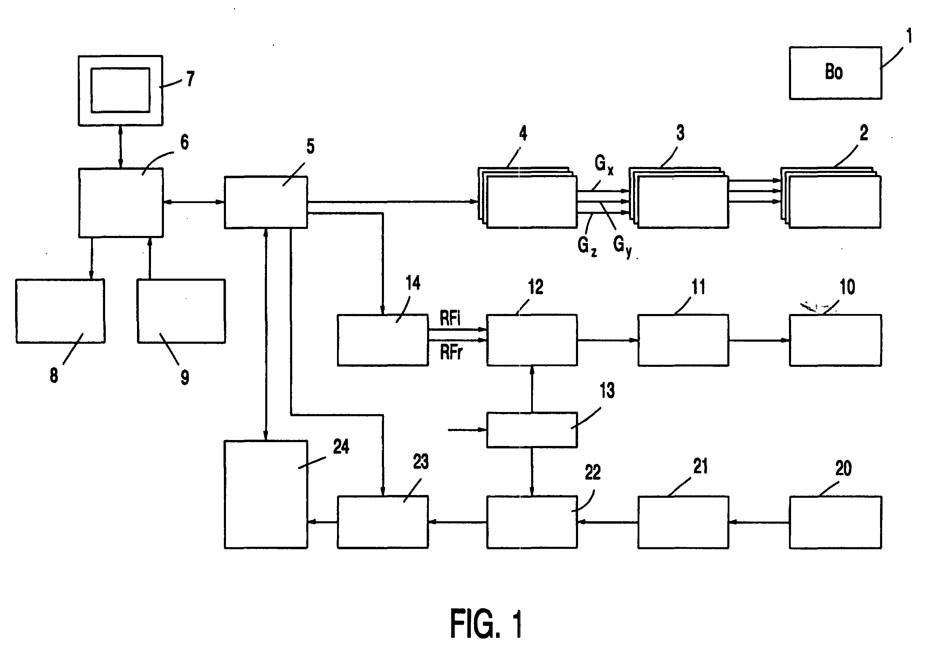

In Fig 1 ist mit 1 ein schematisch dargestellter Hauptfeldmagnet bezeichnet, der in einem nicht näher dargestellten Untersuchungsbereich ein in z-Richtung verlaufendes, stationäres und im wesentlichen homogenes Magnetfeld $B_0$ mit einer Stärke von z.B. 1,5 Tesla erzeugt. Die z-Richtung verläuft dabei in Längsrichtung eines nicht näher dargestellten Untersuchungtisches, auf dem sich während einer Untersuchung ein Patient befindet.

Weiterhin ist eine Gradientenspulen-Anordnung 2 vorgesehen, die drei Spulensysteme umfaßt, mit denen in z-Richtung verlaufende Gradienten-Magnetfelder $G_x$, $G_y$ bzw. $G_z$ mit einem Gradienten in x, y bzw. z-Richtung erzeugt werden können. Die Ströme für die Gradientenspulen-Anordnung 2 werden von einem Gladientenverstärker 3 geliefert. Ihr zeitlicher Verlauf wird von je einem Waveform- Generator vorgegeben und zwar für jede Richtung gesondert. Der Waveform-Generator 4 wird von einer Rechen- und Steuereinheit 5 gesteuert, die den für ein bestimmtes Untersuchungsverfahren erforderlichen zeitlichen Verlauf der magnetischen Gradientenfelder $G_x$, $G_y$, $G_z$ berechnet und in den Waveform-Generator 4 lädt. Bei der MR-Untersuchung werden diese Signale aus dem Waveform-Generator 4 ausgelesen und den Gradientenverstärkern 3 zugeführt, die daraus die für die Gradientenspulen-Anordnung 2 erfordedichen Ströme erzeugt.

Die Steuereinheit 5 wirkt außerdem noch auf eine Work-Station 6 ein, die mit einem Monitor 7 zur Wiedengabe von MR-Bildern versehen ist. Über eine Tastatur 8 oder eine interaktive Eingabeeinheit 9 sind Eingaben möglich.

Die Kernmagnetisierung im Untersuchungsbereich kann durch Hochfrequenzimpulse einer Hochfrequenzspule 10 angeregt werden, die an einen Hochfrequenzverstärker 11, angeschlossen ist, der die Ausgangssignale eines Hochfrequenzsenders 12 verstärkt. In dem Hochfrequenzsender 12 werden die (komplexen) Einhüllenden der Hochfrequenzimpulse auf die von einem Oszillator 13 gelieferten Trägerschwingungen moduliert, deren Frequenz im wesentlichen der Larmofrequenz (bei einem Hauptmagnetfeld von 1,5 Tesla ca. 63 MHz) entspricht. Die Frequenz und die Phasenlage bzw. die komplexe Einhüllende der Hochfrequenzimpulse wird von der Rechen- und Steuereinheit 5 in einen Generator 14 geladen, der mit dem Sender 12 gekoppelt ist.

Die im Untersuchungsbereich erzeugten MR-Signale werden von einer Empfangsspule 20 aufgenommen und von einen Verstärker 21 verstärkt. Das verstäkte MR-Signal wind in einem Quadratur-Demodulator 22 durch zwei um 90° gegeneinander versetzte Trägerschwingungen des Oszillators 13 demoduliert, so dass sich ein komplexes MR-Signal ergibt, dessen Phase ebenfalls durch die Steuereinheit 5 steuerbar ist. Die komplexen MR-Signale werden einem Analog-Digitalwandler 23 zugeführt, der daraus MR-Daten bildet. Die MR-Daten werden in einer Auswerteeinheit 24 verschiedenen Verarbeitungsschritten unterzogen u.a. einer Fourier-Transformation, zwecks Erzeugung von MR-Bildern.

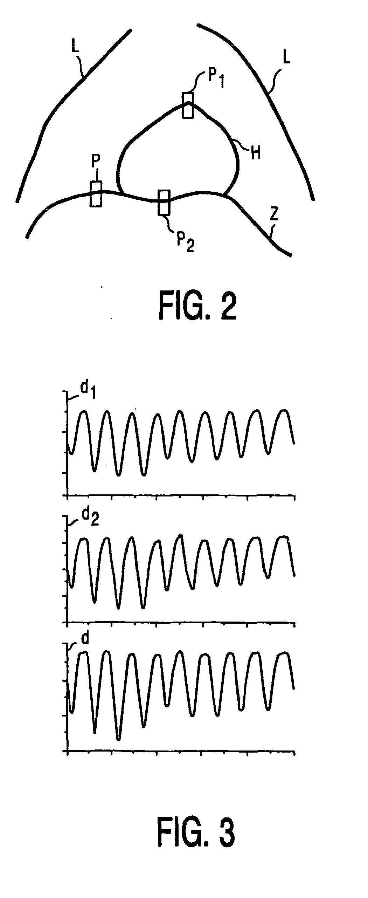

Fig. 2 zeigt schematisch die Lage des Herzens H im Brustraum eines Patienten, das möglichst frei von Bewegungsartefakten in einer MR-Untersuchung dargestellt werden soll.

Man erkennt außerdem das Zwerchfell Z und die Lungenflügel L. Außerdem sind drei Meßpunkte dargestellt, an denen die Bewegung gemessen wird. Der Meßpunkt P liegt auf dem Zwerchfell rechts neben dem Herzen (in der Darstellung der Fig. 2 ist das links). Der Meßpunkt P1 liegt am oberen Hetzrand und der Meßpunkt P2 am unteren Herzrand. Die Erfindung basiert auf der Annahme, dass sich die durch die Atmung induzierte Bewegung eines beliebigen Punktes am Herzen durch eine affine Transformation gemäß der Gleichung

$$R(r,t) = A(t) \cdot r_0 + r(t) \qquad (1)$$

beschreiben läßt. Dabei ist R (r,t) der Pfad den dieser Punkt bei der Atembewegung durchläuft. A(t) ist eine globale (d.h. für alle Punkte auf dem belegten Objekt geltende), zeitabhängige (3 x 3) Transformationsmatrix, die die Rotation und Expansion des bewegten Objektes H beschreibt. Der dreidimensionale Vektor $r_0$ definiert die Lage eines beliebigen anatomischen Punktes auf dem Objekt H und r(t) ist ein Vektor, der die globale, zeitabhängige Verschiebung des Objektes H beschreibt. Die durch Gleichung 1 beschriebene Bewegung des Herzens läßt sich kompensieren (d.h. es läßt sich

3

ein MR-Bild erzeugen, das das bewegte Objekt als unbewegt erscheinen läßt), wenn die Parameter der bildgebenden Sequenz wie folgt geändert werden:

a) Anstelle des magnetischen Gradientenfeldes G(t) bei dem es sich um einen Vektor mit den zeitabhängigen Komponenten $G_x$, $G_y$, und $G_z$ handelt, wird ein kompensierendes magnetisches Gradientenfeld $G_c$ (t) verwendet, das sich nach der Formel

$$G_c(t) = \left(A^{-1}(t)\right)^T \cdot G(t) \qquad (2)$$

berechnet; $(A^{-1}(t))^T$ ist dabei die zu der Matrix A(t) inverse transponierte Matrix. Dadurch werden Rotation bzw. Expansion des bewegten Objekts kompensiert.

b) Die Phase des während des Hochfrequenzimpulses auf den Untersuchungbereich einwirkenden Hochfrequenzmagnetfeldes wird mit einen Phasenfaktor $\Phi_s$ moduliert nach der Beziehung

$$\Phi_s(t) = e^{i\gamma u(t)} \qquad (3)$$

Für u(t) gilt dabei

$$u(t) = \int_t^{t1} G_c(t')^T r(t') \, dt' \qquad (4)$$

$G_c(t')^T$ ist dabei der (durch Vertauschen der Zeilen und Spalten der Matrix G(t) entstehende) transponierte Vektor. Die Größe $t_1$ bezeichnet das Ende eines Hochfrequenzimpulses.

c) Das MR-Signal wird mit einem Phasenfaktor $\Phi_e$(t) nach der Beziehung moduliert

$$\Phi_e(t) = e^{i\gamma v(t)} \qquad (5)$$

Für v(t) gilt dabei

$$v(t) = \int_{t1}^{t} G_c(t')^T r(t') \, dt' \qquad (6)$$

Die unter b) und c) angegebene Phasenmodulation des Hochfrequenzimpules bzw. des MR Signales verändert die Frequenz bzw. die Phase dieser Signale, wodurch die Translation des Objektes H für die MR-Bildgebung kompensiert wird.

In der der eigentlichen MR-Untersuchung vorangehenden Präparationsphase müssen die neun Elemente der Matrix A(t) und die drei Komponenten des Vektors r(t) bestimmt werden. Dazu müßten - vorausgesetzt die Elemente der Matrix A(t) sind voneinander linear unabhängig- bis zu 12 Bewegungsparameter gemessen werden. Man kann diese Messung aber deutlich vereinfachen, wenn man davon ausgeht, dass sich das Objekt nur in z-Richtung, also in Längsrichtung des Patienten, bewegt bzw. expandiert. Der Vektor r(t) vereinfacht sich dann zu

$$r(t) = \begin{pmatrix} 0 \\ 0 \\ f(t) \end{pmatrix} \qquad (7)$$

und die Matrix A von t geht dann über in

$$A(t) = \begin{pmatrix} 1 & 0 & 0 \\ 0 & 1 & 0 \\ 0 & 0 & b(t) \end{pmatrix} \qquad (8)$$

Für dieses vereinfachte Bewegungsmodell müssen lechglidi zwei Bewegungsparameter gemessen werden, zB. die Verschiebung des oberen und unteren Herzrandes an den Punkten $P_1$ und $P_2$ in Fig 2.

Zunächst wird daher in der Präparationsphase über einige Atemzyklen hinweg die Verschiebung der Punkte P, $P_1$ und $P_2$ in z-Richtung mittels geeigneter Navigatorimpulse gemessen. Fig 3 zeigt den zeitlichen Verlauf der für die Punkte P, $P_1$ und $P_2$ ermittelten Verschiebung d, $d_1$ und $d_2$. Man erkennt, dass sich das Zwerchfell unter der Atembewegung stärker verschiebt, als der obere und der untere Herzrand. Die Verschiebung $d_2$ des unteren Herzrandes ist größer als die Verschiebung $d_1$ des oberen Herzrandes.

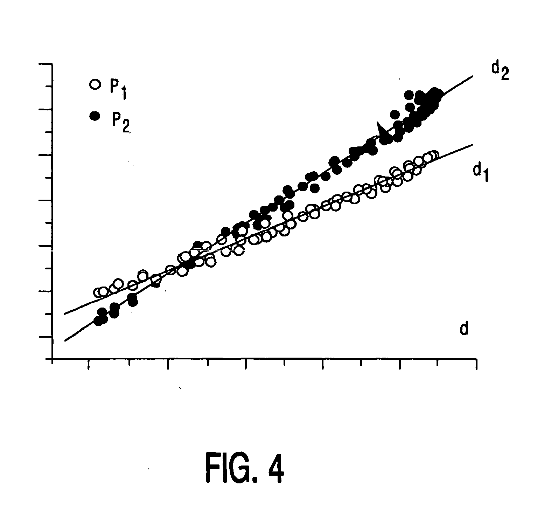

Trägt man die zu bestimmten Zeitpunkten ermittelten Werte von $d_1$ und $d_2$ als Funktion des zum selben Zeitpunkt in der sich wiederholenden Atembewegung ermittelten Wertes d auf, dann ergibt sich die in Fig 4 dargestellte Abhängigkeit dieser Werte, die die Korrelation dieser Werte beschreibt. Somit muß man bei der nachfolgenden MR-Untersuchung nicht mehr die Werte $d_1$ und $d_2$ messen, sondern lediglich die Größe d, d.h. die Bewegung des Zwerchfells. Die zugehörigen Werte von $d_1$ und $d_2$ ergeben sich dann unmittelbar aus der in Fig. 4 dargestellten Korrelation (diese Korrelation kann man durch je eine Gerade approximieren). Die Parameter b(t) und f(t) ergeben sich damit zu

$$b(t) = \frac{d_1(t) - d_2(t)}{d_{1o} - d_{2o}} \qquad (9)$$

$$f(t) = d_1(t) - \frac{d_1(t) - d_2(t)}{d_{1o} - d_{2o}} d_{1o} \qquad (10)$$

$d_{10}$ und $d_{20}$ stellen dabei die Werte $d_1$ und $d_2$ an einem frei wählbaren Referenzpunkt dar, zB. am Ende der Ausatmung.

Bei der nachfolgenden MR-Untersuchung muß nun - neben den bildgebenden MR-Signalen lediglich der Parameter d gemessen werden. Mit Hilfe der in Fig 4 dargestditen Korrelation können dann die Werte b(t) und f(t) gemäß Gleichung 9 und 10 ermittelt werden, aus denen sich die Matrix A(t) und der Vektor r(t) gemäß Gleichung 7 und 8 ableiten lassen, woraus sich wiederwn die Parameter $G_c(t)$, $\Phi_s(t)$ $\Phi_e(t)$ gemäß den Gleichungen 2, 3 und 5 berechnen lassen.

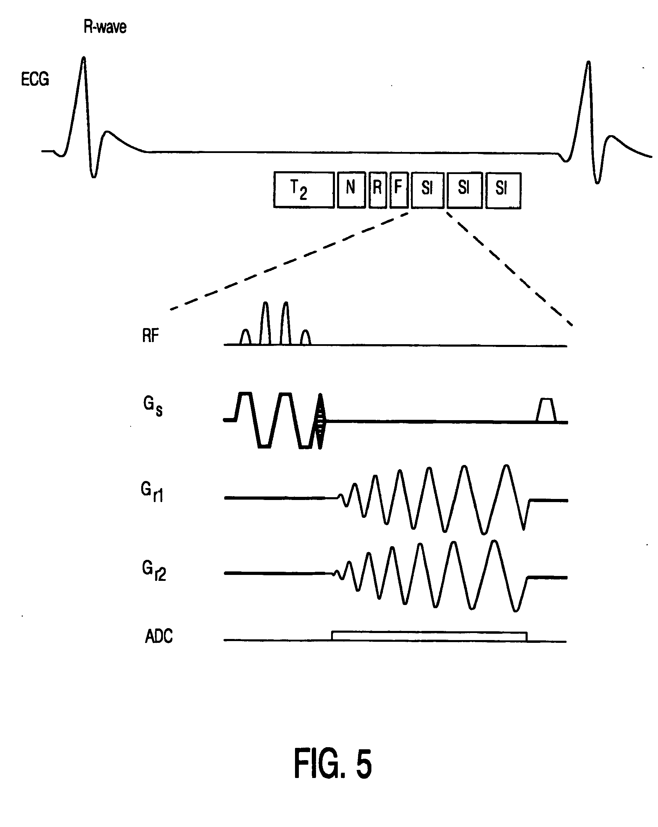

Fig. 5 zeigt die zeitliche Lage der bildgebenden Sequenzen während der eigentlichen MR-Untersuchung in Relation zu dem zeitlichen Verlauf eines EKG-Signals (1. Zeile von Fig 5) während eines einzelnen Herzzyklus. Wie durch die darunter befindlichen Blöcke angedeutet, umfaßt die MR-Bildgebung eine sogenannte $T_2$-Präparation ($T_2$) - die nicht mit der erfindungsgemäß vorgesehenen Präparationsphase verwechselt werden darf. Danach wird ein Navigatorimpuls (N) erzeugt, der die Kernmagnetisierung oberhalb des Punktes P (vgl. Fig 2) in einem bleistiftförmigen Bereich anregt. Aus den dabei erzeugten MR-Signalen läßt sich die Lage d des Zwerchfells während des Herzzyklus ermitteln, die während des verbleibenden Teils des Herzzyklus als konstant angesehen werden kann. Danach können die zeitlichen Verläufe wn $G_c(t)$, $\varphi_e(t)$ und $\varphi_s(t)$ vorausberechnet und gespeichert werden (z.B. im Waveform-Generator 4, Fig 1). Vor den eigentlichen Bildgebungssequenzen (SI) kann dann noch ein regionaler Unterdrückungspuls und eine Fettunterdrückungssequenz (F) erzeugt werden, doch können diese Maßnahmen auch entfallen.

Um eine Bewegungskompensation zu erreichen, müssen die Parameter in der nachfolgenden Sequenz geändert wenden. Der zeitliche Verlauf des Gradientenmagnetfeldes $G(t) = (G_s(t), G_{r1}(t), G_{r2}(t))$ muß entsprechend Gleichung 2 für den mit dem Navigatorimpuls (N) ermittelten Wert von d geändert werden. Die Phase der Hochfrequenzschwingung während des Hochfrequenzimpulses RF muß mit dem Wert $\Phi_s$ gemäß Gleichung 3 moduliert werden, und das empfangene MR-Signal mit dem Phasenfaktor $\Phi_e$ gemäß Gleichung 5.

Darauf folgen in der späten Phase der Diastole des Herzzyklus drei bildgebende Sequenzen mit - wie erläutert - in Abhängigkeit von der gemessenen Position d des Zwerchfells Z modifierten Parametern. Eine dieser Sequenzen ist in Fig. 5 dargestellt.

Die dritte Zeile von Fig 5 stellt die Umhüllende eines Hochfrequenzimpulses RF dar, dessen peaks jeweils mit der positiven bzw. negativen Polarität eines schichtselektiven Gradienten $G_s$ (2. Zeile) zusammenfallen. Nach dem Hochfrequenzimpulses RF erfolgt eine Phasenkodierung durch Einschaltung des Gradienten $G_s$ mit einer definierten Dauer und einer vorgabbaren Amplitude Im Anschluß daran wird ein MR-Signal mit Hilfe zweier zueinander und zum Gradienten $G_s$ senkrechter periodischer Lesegradienten (5. und 6. Zeile von Fig. 5) $G_{r1}$ und $G_{r2}$ mit zunehmender Amplituden ausgelesen (7. Zeile). Dadurch wird die Kernmagnetisierung im sogenannten k-Raum längs eines Spiralarms abgetastet. Die Sequenz endet dadurch, dass die angeregte Kernmagnetisierung durch einen sogenannten "Spoiler" des Gradienten $G_s$ dephasiert wird. Danach folgt die nächste Sequenz, wobei jedoch die nächsten Gradienten $G_{r1}$ und $G_{r2}$ so modifiziert sind, dass der dann im k-Raum durchlaufene Spiralarm gegenüber dem vorherigen um z.B. 120° versetzt (oder eine andere Phasenkodierung erfährt).

Die MR-Bildgebung kann auch mit anderen Sequenzen durchgeführt werden, die eine zwei- bzw. dreidimensionale Darstellung ermöglichen, z.B. mit einer sogenannten 3-DFT-Sequenz.

Weiterhin kann auch ein sogenanntes Gating angewandt werden, bei dem nur die MR-Signale für ein MR-Bild herangezogen werden, die in bestimmten Phasen der Atmung akquiriert wurden. Dadurch können die trotz Bewegungskompensation durch die Bewegung verbleibenden Artefakte verringert werden-allerdings auf Kosten einer längeren Akquisitionszeit. Allerdings ist die Verlängerung nicht so groß, wie bei den Verfahren, bei denen ohne jede Bewegungskompensation die Bewegungsartefakte ausschließlich durch ein Gating vermieden werden sollen, weil hierbei nur immer in einem kleinen Bereich des Atmungszyklus MR-Signale akquiriert werden können.

Die Erfindung ist auch bei der Darstellung anderer bewegter Organe anwendbar, z.B. der Leber oder der bzw. den Nieren(n). Schließlich ist das erfindungsgemäße MR-Verfahren nicht nur bei der Untersuchung des menschlichen Körpers anwendbar, sondern auch bei anderen biologischen oder technischen Systemen.

**Patentansprüche**

1. MR-Verfahren zur Darstellung eines zumindest teilweise bewegten Objektes (H) in einem Untersuchungsbereich, wobei während einer MR-Untersuchung in Anwesenheit eines stationären Magnetfeldes die Kernmagnetisierung durch Sequenzen (SI) mit mindestens je einem Hochfrequenzimpuls (RF) mit definierter Frequenz angeregt und eine Anzahl von unter dem Einfluß von zusätzlichen magnetischen Gradientenfeldern entstandenen, mit definierter Phasenlage empfangenen MR-Signalen ausgewertet wird und wobei zur Bewegungskompensation ein Bewegungsparameter des Objekts fortlaufend gemessen und die Parameter der Sequenz in Abhängigkeit von der Messung variiert werden, **gekennzeichnet durch** folgende Maßnahmen:

   Messung des zeitlichen Verlaufs von n miteinander korrelierten Bewegungsparametem ($d$, $d_1$, $d_2$) während einer der MR-Untersuchung vorangehenden Präparationsphase, wobei jeder Bewegungsparameter ($d$, $d_1$, $d_2$) die zeitabhängige Verschiebung eines jeweils anderen Objektpunktes ausdrückt,
   - Ermittlung der Korrelation zwischen den Bewegungsparametern ($d$, $d_1$, $d_2$) auf der Basis dieser Messung,
   - Messung von m dieser n Bewegungsparameter ($d$) während der MR-Untersuchung, wobei m<n,
   - Ermittlung der während der MR-Untersuchung nicht gemessenen Bewegungsparameter ($d_1$, $d_2$) anhand der gemessenen Bewegungsparameter ($d$) und der ermittelten Korrelation,
   - Variation der Parameter der Sequenz in Abhängigkeit von den ermittelten Bewegungsparametern zur Bewegungskompensation.

2. MR-Verfahcen nach Anspruch 1
   **gekennzeichnet durch** folgende Maßnahmen:

   - Ableitung von mindestens zwei Bewegungsparametern für eine Bewegungsrichtung aus den gemessenen Bewegungsparametern,
   - Bewegungskompensation zusätzlich **durch** Variation der magnetischen Gradientenfelder.

3. MR-Verfahren nach Anspruch 1, **gekennzeichnet durch** die Verwendung von Navigatorimpulsen zur Messung der Bewegungsparameter.

4. MR-Verfahren nach Anspruch 1 zur Darstellung des Herzes,

**gekennzeichnet durch** eine EKG-gesteuerte Erzeugung der Sequenzen.

5. MR- Verfahren nach Anspruch 4
**gekennzeichnet durch** die Erzeugung mehrerer, nach einer Messung der Bewegungsparameter aufeinanderfolgender Sequenzen pro Herzzyklus.

6. MR-Gerät zur Durchführung des Verfahrens nach Anspruch 1, enthaltend

• einen Magneten (1) zur Erzeugung eines homogenen, stationären Magnetfeldes einen Hochfrequenzsender (12) zur Erzeugung von magnetischen Hochfrequenzimpulsen,
• einen Empfänger (22) zum Empfangen von MR-Signalen,
• einen Generator (4) zur Erzeugung von Gradienten-Magnetfeldern mit zeitlich und räumlich unterschiedlich verlaufenden Gradienten,
• eine Auswerteeinheit (24) zur Verarbeitung der empfangenen MR-Signale und
• eine den Hochfrequenzsender, den Empfänger, den Generator, und die Auswerteeinheit steuernden Steuereinheit (5), die so programmiert ist, dass folgende Schritte ausgeführt werden:

- Messung des zeitlichen Verlaufs von n miteinander korrelierten Bewegungsparametern während einer der MR-Untersuchung vorangehenden Präparationsphase, wobei jeder Bewegungsparameter die zeitabhängige Verschiebung eines jeweils anderen Objektpunktes ausdrückt,
- Ermittlung der Korrelation zwischen den Bewegungsparametern auf der Basis dieser Messung,
- Messung von m dieser n Bewegungsparameter während der MR-Untersuchung, wobei m<n,
- Ermittlung der während der MR-Untersuchung nicht gemessenen Bewegungsparameter anhand der gemessenen Bewegungsparameter und der ermittelten Korrelation,
- Variation der Parameter der Sequenz in Abhängigkeit von den ermittelten Bewegungsparametern zur Bewegungskompensation.

7. Computerprogramm für eine Steuereinheit zur Steuerung eines MR-Gerätes zur Durchführung des Verfahrens nach Anspruch 1 gemäß folgendem Ablauf:

- Messung des zeitlichen Verlaufs von n miteinander korrelierten Bewegungsparametern während einer der MR-Untersuchung vorangehenden Präparationsphase, wobei jeder Bewegungsparameter die zeitabhängige Verschiebung eines jeweils anderen Objektpunktes ausdrückt,
- Ermittlung der Korrelation zwischen den Bewegungsparametern auf der Basis dieser Messung,
- Messung von m dieser n Bewegungsparameter während der MR-Untersuchung, wobei m<n,
- Ermittlung der während der MR-Untersuchung nicht gemessenen Bewegungsparameter anhand der gemessenen Bewegungsparameter und der ermittelten Korrelation,
- Variation der Parameter der Sequenz in Abhängigkeit von den ermittelten Bewegungsparametern zur Bewegungskompensation.

**Claims**

1. An MR method for the imaging of an at least partly moving object (H) in an examination zone, wherein the nuclear magnetization is excited during an examination in the presence of a steady magnetic field by sequences (SI) which include at least a respective RF pulse (RF) of defined frequency, a number of MR signals received with a defined phase position and produced under the influence of additional magnetic gradient fields are evaluated, a motion parameter of the object is continuously measured for motion compensation and the parameters of the sequence are varied in dependence on the measurement, **characterized in that** the following steps are taken:

- measuring the variation in time of n correlated motion parameters ($d$, $d_1$, $d_2$) during a preparation phase preceding the MR examination, and determining the correlation between the motion parameters on the basis of the measurement where each motion parameter ($d$, $d_1$, $d_2$) expresses the time-dependent shift each time of another object point,
- measuring m of such n motion parameters ($d$) during the MR examination, where m<n,
- calculation of the motion parameters ($d_1$, $d_2$) that have not been measured during the MR examination, which calculation is based on the measured motion parameters and the determined correlation,
- varying the parameters of the sequence in dependence on the calculated motion parameters in order to achieve motion compensation.

2. An MR method as claimed in claim 1, **characterized in that** it includes the following steps:

- deriving at least two motion parameters for a motion direction from the measured motion parameters,
- compensating motion additionally by varying the magnetic gradient fields.

3. An MR method as claimed in claim 1, **characterized in that** navigator pulses are used for the measurement of the motion parameters.

4. An MR method as claimed in claim 1 for the imaging of the heart, **characterized in that** the sequences are generated under the control of an ECG.

5. An MR method as claimed in claim 4, **characterized in that** per cardiac cycle a number of successive sequences are generated after measurement of the motion parameters.

6. An MR apparatus for carrying out the method claimed in claim 1, comprising

- • a magnet (1) for generating a uniform, steady magnetic field,
- • an RF transmitter (12) for generating magnetic RF pulses,
- • a receiver (22) for receiving MR signals,
- • a generator (4) for generating gradient magnetic fields with gradients that vary differently in time and in space,
- • an evaluation unit (24) for processing the received MR signals, and
- • a control unit (5) which controls the RF transmitter, the receiver, the generator and the evaluation unit and is programmed in such a manner that the following steps are executed:

- measuring the variation in time of n correlated motion parameters during a preparation phase preceding the MR examination, and determining the correlation between the motion parameters on the basis of the measurement where each motion parameter ($d$, $d_1$, $d_2$) expresses the time-dependent shift each time of another object point,
- measuring m of such n motion parameters during the MR examination, where $m<n$,
- calculation of the motion parameters that have not been measured during the MR examination, which calculation is based on the measured motion parameters and the determined correlation,
- varying the parameters of the sequence in dependence on the calculated motion parameters in order to achieve motion compensation.

7. A computer program for a control unit for controlling an MR apparatus for carrying out the method claimed in claim 1 as follows:

- measuring the variation in time of n correlated motion parameters during a preparation phase preceding the MR examination, and determining the correlation between the motion parameters on the basis of the measurement where each motion parameter ($d$, $d_1$, $d_2$) expresses the time-dependent shift each time of another object point,
- measuring m of such n motion parameters during the MR examination, where $m<n$,
- calculation of the motion parameters that have not been measured during the MR examination, which calculation is based on the measured motion parameters and the determined correlation,
- varying the parameters of the sequence in dependence on the calculated motion parameters in order to achieve motion compensation.

## Revendications

1. Procédé RM pour la représentation d'un objet (H) déplacé, du moins partiellement, dans une zone d'examen, dans lequel, pendant un examen RM en présence d'un champ magnétique stationnaire, la magnétisation nucléaire est excitée par des séquences (SI) avec, à chaque fois, au moins une impulsion à haute fréquence (RF) de fréquence définie et un nombre de signaux RM reçus avec une position de phase définie et obtenus sous l'influence de champs à gradient magnétiques supplémentaires et dans lequel, pour la compensation du mouvement, un paramètre de mouvement de l'objet est mesuré en continu et les paramètres de la séquence varient en fonction de la mesure,

**caractérisé par** les mesures suivantes :

• mesure du tracé temporel de n paramètres de mouvement corrélés l'un à l'autre (d, $d_1$, $d_2$) pendant une phase de préparation préalable à l'examen RM, dans laquelle chaque paramètre de mouvement (d, $d_1$, $d_2$) exprime le déplacement en fonction du temps d'un autre point objet respectif,
• détermination de la corrélation entre les paramètres de mouvement (d, $d_1$, $d_2$) sur la base de cette mesure,
• mesure de m de ces n paramètres de mouvement (d) pendant l'examen RM, m étant < n;
• détermination des paramètres de mouvement ($d_1$, $d_2$) non mesurés pendant l'examen RM à l'aide des paramètres de mouvement (d) mesurés et de la corrélation déterminée;
• variation des paramètres de la séquence en fonction des paramètres de mouvement déterminés pour la compensation du mouvement.

2. Appareil RM selon la revendication 1
   **caractérisé par** les mesures suivantes :

   • déduction d'au moins deux paramètres de mouvement pour une direction de mouvement à partir des paramètres de mouvement mesurés;
   • compensation du mouvement en plus par variation des champs à gradient magnétiques.

3. Appareil RM selon la revendication 1,
   **caractérisé par** l'utilisation d'impulsions de navigateur pour la mesure des paramètres de mouvement.

4. Procédé RM selon la revendication 1 pour la représentation du coeur, **caractérisé par** une production des séquences commandée par ECG.

5. Procédé RM selon la revendication 4,
   **caractérisé par** la production de plusieurs séquences successives après une mesure des paramètres de mouvement par cycle cardiaque.

6. Appareil RM pour l'exécution du procédé selon la revendication 1, contenant

   • un aimant (1) pour la production d'un champ magnétique stationnaire homogène;
   • un émetteur à haute fréquence (12) pour la production d'impulsions magnétiques à haute fréquence;
   • un récepteur (22) pour la réception de signaux RM;
   • un générateur (4) pour la production de champs magnétiques à gradient avec des gradients évoluant différemment dans le temps et l'espace;
   • une unité d'évaluation (24) pour le traitement des signaux RM reçus et
   • une unité de commande (5) commandant l'émetteur à haute fréquence, le récepteur, le générateur et l'unité d'évaluation, qui est programmée de telle sorte que les étapes suivantes soient exécutées :
   • mesure du tracé temporel de n paramètres de mouvement corrélés l'un à l'autre pendant une phase de préparation préalable à l'examen RM, dans laquelle chaque paramètre de mouvement exprime le déplacement en fonction du temps d'un autre point objet respectif,
   • détermination de la corrélation entre les paramètres de mouvement sur la base de cette mesure,
   • mesure de m de ces n paramètres de mouvement pendant l'examen RM, m étant < n;
   • détermination des paramètres de mouvement non mesurés pendant l'examen RM à l'aide des paramètres de mouvement mesurés et de la corrélation déterminée;
   • variation des paramètres de la séquence en fonction des paramètres de mouvement déterminés pour la compensation du mouvement.

7. Programme informatique pour une unité de commande en vue de la commande d'un appareil RM pour l'exécution du procédé selon la revendication 1, comprenant le déroulement suivant :

   • mesure du tracé temporel de n paramètres de mouvement corrélés l'un à l'autre pendant une phase de préparation préalable à l'examen RM, dans laquelle chaque paramètre de mouvement exprime le déplacement en fonction du temps d'un autre point objet respectif,
   • détermination de la corrélation entre les paramètres de mouvement sur la base de cette mesure,
   • mesure de m de ces n paramètres de mouvement pendant l'examen RM, m étant < n;
   • détermination des paramètres de mouvement non mesurés pendant l'examen RM à l'aide des paramètres de mouvement mesurés et de la corrélation déterminée;
• variation des paramètres de la séquence en fonction des paramètres de mouvement déterminés pour la compensation du mouvement.

FIG. 1

EP 1 164 382 B1

FIG. 2

FIG. 3

FIG. 4

FIG. 5